# EUROPEAN PATENT APPLICATION

(11) **EP 4 141 928 A1**
(43) Date of publication of application: **01.03.2023**
(21) Application number: 22191950.9
(22) Date of filing: 24.08.2022
(51) Int. Cl.: H01L 23/64, H10N 97/00

(54) **INTEGRATED HIGH VOLTAGE ISOLATION CAPACITOR AND DIGITAL CAPACITIVE ISOLATOR**

(30) Priority: 24.08.2021 CN 202110971795
(71) Applicant: Huawei Digital Power Technologies Co., Ltd., Shenzhen, 518043 (CN)
(72) Inventor: TANG, Fengjie, Shenzhen, 518129 (CN)
(74) Representative: Gill Jennings & Every LLP

(57) **Abstract**

An integrated high voltage isolation capacitor and a digital capacitive isolator are provided. The integrated high voltage isolation capacitor includes: a substrate and a semiconductor component; a wiring layer located on one side of the substrate and the semiconductor component, where the wiring layer has a bonding part; and an isolation capacitor unit located on one side that is of the wiring layer and that faces away from the substrate and the semiconductor component, where a vertical projection of the isolation capacitor unit on the substrate and the semiconductor component does not overlap with a vertical projection of the bonding part on the substrate and the semiconductor component. In a direction in which the substrate and the semiconductor component point to the wiring layer, the isolation capacitor unit includes a bottom electrode plate, a dielectric structure layer, and a top electrode plate that are disposed in a stacked manner. A withstand voltage value of the isolation capacitor unit can be adjusted by directly adjusting a thickness of the dielectric structure layer. The thickness of the dielectric structure layer in the integrated high voltage isolation capacitor does not depend on a quantity of metal layers at the wiring layer, and isolation capacitor units obtained at wiring layers with different quantities of metal layers may be the same.

## Description

### TECHNICAL FIELD

This application relates to the field of digital isolator technologies, and in particular, to an integrated high voltage isolation capacitor and a digital capacitive isolator.

### BACKGROUND

A digital capacitive isolator has become a mainstream application in an isolator market because of advantages such as a fast data transfer speed, high signal integrity, low power consumption, a strong anti-magnetic capability, a compatible standard CMOS (complementary metal oxide semiconductor, complementary metal-oxide-semiconductor) process, low costs, and a high withstand voltage.

The digital capacitive isolator includes a high voltage isolation capacitor, and withstand voltage performance of an isolation capacitor unit in the high voltage isolation capacitor is positively correlated with a thickness of a dielectric layer. In an existing integrated high voltage isolation capacitor, a thickness of a dielectric layer depends on a quantity of mutually connected metal layers in a back-end process of a wiring layer, a smaller quantity of metal layers indicates a lower withstand voltage value of an isolation capacitor unit, and the withstand voltage value cannot be flexibly adjusted based on a requirement. In another existing integrated high voltage isolation capacitor, a dielectric layer covers a wiring layer, and process difficulty or costs are increased.

Therefore, how to provide an integrated high voltage isolation capacitor that can meet different withstand voltage requirements and is easy to manufacture is an urgent problem to be resolved.

### SUMMARY

This application provides an integrated high voltage isolation capacitor and a digital capacitive isolator, to provide an integrated high voltage isolation capacitor that can meet different withstand voltage requirements and is easy to manufacture.

According to a first aspect, this application provides an integrated high voltage isolation capacitor. The integrated high voltage isolation capacitor includes a substrate, a semiconductor component, a wiring layer, and at least one isolation capacitor unit that are sequentially disposed in a stacked manner. Specifically, the isolation capacitor unit is disposed on one side that is of the wiring layer and that faces away from the substrate and the semiconductor component, and a vertical projection of the isolation capacitor unit on the substrate and the semiconductor component does not overlap with a vertical projection, of a bonding part that is of the wiring layer and that is used for packaging and wire bonding, on the substrate and the semiconductor component. In a direction in which the substrate and the semiconductor component point to the wiring layer, the isolation capacitor unit includes a bottom electrode plate, a dielectric structure layer, and a top electrode plate that are sequentially disposed in a stacked manner in a direction that faces away from the substrate and the semiconductor component. In other words, the dielectric structure layer of the isolation capacitor unit does not cover the bonding part of the wiring layer, to help connect the wiring layer and an external line, so as to simplify a manufacturing process and reduce production costs.

In the integrated high voltage isolation capacitor, the isolation capacitor unit is disposed on a top side of the wiring layer, and a withstand voltage value of the isolation capacitor unit can be adjusted by directly adjusting a thickness of the dielectric structure layer. Because the thickness of the dielectric structure layer in the integrated high voltage isolation capacitor provided in this application does not depend on a quantity of metal layers at the wiring layer, isolation capacitor units obtained at wiring layers with different quantities of metal layers may be the same.

When a structure of the isolation capacitor unit is specifically disposed, the dielectric structure layer between the bottom electrode plate and the top electrode plate may be disposed in a plurality of forms, and may be disposed in at least one of the following several forms.

In a possible specific implementation, the dielectric structure layer is of a single-layer structure. Specifically, the dielectric structure layer includes only a first dielectric layer, and a manufacturing material of the first dielectric layer is silicon dioxide. It should be noted that, a withstand voltage value of silicon dioxide with a unit thickness is approximately 500 Vrms/um, and the withstand voltage value of the isolation capacitor unit may be improved by using the silicon dioxide as the first dielectric layer. In a specific setting, it may be set that a thickness of the first dielectric layer is 1 um to 12 um in the direction in which the substrate and the semiconductor component point to the wiring layer.

In another possible specific implementation, the dielectric structure layer is of a double-layer structure. Specifically, in the direction in which the substrate and the semiconductor component point to the wiring layer, the dielectric structure layer includes a first dielectric layer and a second dielectric layer that are disposed in a stacked manner. A manufacturing material of one of the first dielectric layer and the second dielectric layer is silicon dioxide, and a manufacturing material of the other one is photosensitive polyimide. Specifically, in this specific implementation, a manufacturing material of the second dielectric layer is photosensitive polyimide when a manufacturing material of the first dielectric layer is silicon dioxide. Alternatively, a manufacturing material of the second dielectric layer is silicon dioxide when a manufacturing material of the first dielectric layer is photosensitive polyimide. Because the photosensitive polyimide has a characteristic similar to that of a photoresist, a uniform film with a specific thickness may be obtained in a manufacturing process, and a customized pattern may be realized. It should be noted that, when the photosensitive polyimide is used as the second dielectric layer, a thickness of the photosensitive polyimide can be freely adjusted to meet different withstand voltage requirements. In this case, there is high flexibility, a manufacturing time period can be reduced, and costs can be reduced.

In another possible specific implementation, the dielectric structure layer is of a three-layer structure. Specifically, in the direction in which the substrate and the semiconductor component point to the wiring layer, the dielectric structure layer includes a first dielectric layer, a second dielectric layer, and a third dielectric layer that are disposed in a stacked manner. A manufacturing material of the first dielectric layer is one of silicon dioxide or silicon nitride, a manufacturing material of the second dielectric layer is photosensitive polyimide, and a manufacturing material of the third dielectric layer is one of silicon dioxide or silicon nitride. It should be understood that the first dielectric layer, the second dielectric layer, and the third dielectric layer form a sandwich structure. The second dielectric layer manufactured by using the photosensitive polyimide is tightly wrapped by the first dielectric layer and the second dielectric layer, to prevent the polyimide from absorbing moisture in an environment and a process, and improve reliability of the isolation capacitor unit. In addition, because the photosensitive polyimide has a characteristic similar to that of a photoresist, a uniform film with a specific thickness may be obtained in a manufacturing process, and a customized pattern may be realized. It should be noted that, when the photosensitive polyimide is used as the second dielectric layer, a thickness of the photosensitive polyimide can be freely adjusted to meet different withstand voltage requirements. In this case, there is high flexibility, a manufacturing time period can be reduced, and costs can be reduced.

For example, in a specific setting, it may be set that in the direction in which the substrate and the semiconductor component point to the wiring layer, a thickness of a first dielectric layer manufactured by using the silicon dioxide is 0.3 um to 1 um, a thickness of the second dielectric layer is 5 um to 30 um, and a thickness of a third dielectric layer manufactured by using the silicon dioxide is 0.3 um to 1 um. It should be understood that, such a disposing form may meet a requirement of the isolation capacitor unit for the withstand voltage value.

The wiring layer in the integrated high voltage isolation capacitor provided in this application includes top metal TM. During specific disposing of the integrated high voltage isolation capacitor, it may be set that the TM and the bottom electrode plate are manufactured at a same layer. In other words, the bottom electrode plate of the isolation capacitor unit and the top metal TM of the wiring layer share a same layer of metal. It should be understood that, because the isolation capacitor unit is disposed on the top side of the wiring layer, a setting of the quantity of metal layers at the wiring layer does not affect the isolation capacitor unit. Therefore, the isolation capacitor unit in the integrated high voltage isolation capacitor provided in this application is compatible with wiring layers with different quantities of metal layers, to implement a large-scale application of a standard process.

There are many possibilities of a manufacturing material of the top electrode plate during disposing of the isolation capacitor unit. For example, the manufacturing material of the top electrode plate is aluminum or copper. It should be noted that a manufacturing process of a top electrode plate manufactured by using aluminum is simpler, and costs may be reduced.

Certainly, a passivation layer may be further formed on one side that is of the top electrode plate and that faces away from the substrate and the semiconductor component, to further protect the isolation capacitor unit. For example, the passivation layer includes a silicon dioxide thin film and a silicon carbide thin film disposed in the direction that faces away from the substrate and the semiconductor component.

According to a second aspect, this application provides a manufacturing method for an integrated high voltage isolation capacitor. The manufacturing method includes:
forming a wiring layer on one side of a substrate and a semiconductor component by using a patterning process; and
forming at least one isolation capacitor unit at the wiring layer by using the patterning process, so that a vertical projection of the isolation capacitor unit on the substrate and the semiconductor component does not overlap with a vertical projection, of a bonding part that is of the wiring layer and that is used for packaging and wire bonding, on the substrate and the semiconductor component, and in a direction in which the substrate and the semiconductor component point to the wiring layer, each isolation capacitor unit includes a bottom electrode plate, a dielectric structure layer, and a top electrode plate that are sequentially disposed in a stacked manner.

In the integrated high voltage isolation capacitor manufactured in the manufacturing method, the isolation capacitor unit is disposed on a top side of the wiring layer, namely, one side that is of the wiring layer and that faces away from the substrate and the semiconductor component. A withstand voltage value of the isolation capacitor unit can be adjusted by directly adjusting a thickness of the dielectric structure layer. It should be understood that the thickness of the dielectric structure layer in the integrated high voltage isolation capacitor provided in this application does not depend on a quantity of metal layers at the wiring layer, and isolation capacitor units obtained at wiring layers with different quantities of metal layers may be the same.

When the at least one isolation capacitor unit is formed at the wiring layer by using the patterning process, the method includes the following example steps:
manufacturing the bottom electrode plate by using the patterning process;
forming a first dielectric layer on the bottom electrode plate by using one of a silicon dioxide material or a silicon nitride material;
forming a second dielectric layer at the first dielectric layer by using a polyimide material;
forming a third dielectric layer at the second dielectric layer by using one of a silicon dioxide material or a silicon nitride material; and
forming a top electrode plate at the third dielectric layer.

It should be understood that the first dielectric layer, the second dielectric layer, and the third dielectric layer form the dielectric structure layer and form a sandwich structure. A second dielectric layer manufactured by using photosensitive polyimide is tightly wrapped by the first dielectric layer and the second dielectric layer, to prevent the polyimide from absorbing moisture in an environment and a process, and improve reliability of the isolation capacitor unit. In addition, because the photosensitive polyimide has a characteristic similar to that of a photoresist, a uniform film with a specific thickness may be obtained in a manufacturing process, and a customized pattern may be realized. It should be noted that, when the photosensitive polyimide is used as the second dielectric layer, a thickness of the photosensitive polyimide can be freely adjusted to meet different withstand voltage requirements. In this case, there is high flexibility, a manufacturing time period can be reduced, and costs can be reduced.

When the second dielectric layer is formed at the first dielectric layer by using the polyimide material, the method includes the following example steps:
spin-coating polyimide, to obtain a uniform film with a specific thickness;
performing photolithography and development on the uniform film, to obtain a pattern of the second dielectric layer; and
performing a high-temperature film hardening process on the pattern of the second dielectric layer, to obtain a stable second dielectric layer.

Because of spin-coating of the photosensitive polyimide and a photolithography process, the thickness of the photosensitive polyimide can be freely adjusted to meet different withstand voltage requirements. In this way, there is high flexibility. In addition, the second dielectric layer supports local customization because of a manufacturing process and a material characteristic of the photosensitive polyimide, to reduce process difficulty and costs without affecting an interconnection structure and performance of a pre-designed wiring layer. It should be noted that because a passivation process in which polyimide is used in a back-end process is completely reused for the photosensitive polyimide, manufacturing costs may not be increased.

A method for forming the bottom electrode plate includes the following example step:
manufacturing top metal TM and the bottom electrode plate of the wiring layer at a same layer by using the patterning process.

It should be understood that, the bottom electrode plate of the isolation capacitor unit and the top metal TM of the wiring layer share a same layer of metal. When the TM and the bottom electrode plate are manufactured at a same layer, because the isolation capacitor unit is disposed on the top side of the wiring layer, a setting of the quantity of metal layers at the wiring layer does not affect the isolation capacitor unit. Therefore, the isolation capacitor unit in the integrated high voltage isolation capacitor provided in this application is compatible with wiring layers with different quantities of metal layers, to implement a large-scale application of a standard process.

According to a third aspect, this application provides a digital capacitive isolator. The digital capacitive isolator includes any integrated high voltage isolation capacitor provided in the first aspect.

### BRIEF DESCRIPTION OF DRAWINGS

FIG. 1 is a diagram of a structure of an integrated high voltage isolation capacitor in the conventional technology;
FIG. 2 is a diagram of another structure of an integrated high voltage isolation capacitor in the conventional technology;
FIG. 3 is a diagram of a line inside a digital capacitive isolator according to an embodiment of this application;
FIG. 4 is a diagram of another line inside a digital capacitive isolator according to an embodiment of this application;
FIG. 5 is a schematic diagram of a structure of a first film layer in an integrated high voltage isolation capacitor according to an embodiment of this application;
FIG. 6 is a schematic diagram of a structure of a second film layer in an integrated high voltage isolation capacitor according to an embodiment of this application;
FIG. 7 is a schematic diagram of a structure of a third film layer in an integrated high voltage isolation capacitor according to an embodiment of this application;
FIG. 8 is a schematic diagram of a structure of a fourth film layer in an integrated high voltage isolation capacitor according to an embodiment of this application;
FIG. 9 is a schematic diagram of a structure of a fifth film layer in an integrated high voltage isolation capacitor according to an embodiment of this application;
FIG. 10 is a schematic diagram of a structure of a sixth film layer in an integrated high voltage isolation capacitor according to an embodiment of this application;
FIG. 11 is a schematic diagram of a structure of a seventh film layer in an integrated high voltage isolation capacitor according to an embodiment of this application; and
FIG. 12 is a flowchart of a manufacturing method for an integrated high voltage isolation capacitor according to an embodiment of this application.

### DESCRIPTION OF EMBODIMENTS

To facilitate understanding of an integrated high voltage isolation capacitor provided in an embodiment of this application, an application scenario of the integrated high voltage isolation capacitor provided in this application is first described. The integrated high voltage isolation capacitor provided in this embodiment of this application may be applied to an integrated circuit system. Because voltages of circuits in which a signal input end and a signal output end are located are different in the integrated circuit system, the circuits are damaged during mutual communication. In this case, a digital isolator needs to be used, to avoid damage to the circuits during mutual communication. The digital isolator mainly includes a magnetic isolator, an optical coupling isolator, and a capacitive isolator based on an isolation manner. A digital capacitive isolator has become a mainstream application in an isolator market because of advantages such as a fast data transfer speed, high signal integrity, low power consumption, a strong anti-magnetic capability, a compatible standard CMOS (complementary metal oxide semiconductor, complementary metal-oxide-semiconductor) process, low costs, and a high withstand voltage. The integrated high voltage isolation capacitor is used as a most crucial part of the digital capacitive isolator, and a withstand voltage value of the integrated high voltage isolation capacitor affects an effect of the digital capacitive isolator.

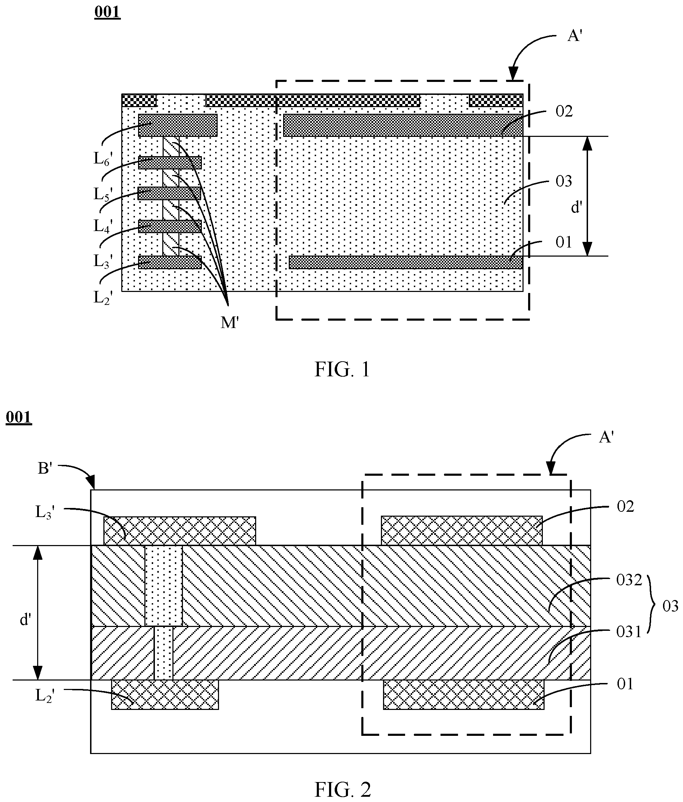

FIG. 1 is a diagram of a structure of an integrated high voltage isolation capacitor in the conventional technology. In the structure shown in FIG. 1, an integrated high voltage isolation capacitor 001 includes an isolation capacitor unit A', the isolation capacitor unit A' includes a bottom electrode plate 01 and a top electrode plate 02 that are disposed opposite to each other, and a dielectric layer 03 is disposed between the bottom electrode plate 01 and the top electrode plate 02. The bottom electrode plate 01 in the isolation capacitor unit A' and a second metal layer L₂' are manufactured at a same layer, the top electrode plate 02 and a sixth metal layer L₆' are manufactured at a same layer, and a through hole M' connects a third metal layer L₃', a fourth metal layer L₄', a fifth metal layer L₅', and the sixth metal layer L₆'.

However, continuing to refer to the structure shown in FIG. 1, a thickness d' of the dielectric layer 03 affects a withstand voltage value of the isolation capacitor unit A', and the thickness d' of the dielectric layer 03 is affected by a quantity of metal layers that are mutually connected through the through hole M' in a back-end process of a wiring layer. Therefore, the withstand voltage value of the isolation capacitor unit A' highly depends on the quantity of metal layers that are mutually connected in the back-end process of the wiring layer. Continuing to refer to the structure shown in FIG. 1, the withstand voltage value of the isolation capacitor unit A' highly depends on thicknesses of the third metal layer L₃', the fourth metal layer L₄', and the fifth metal layer L₅' and a distance between the third metal layer L₃', the fourth metal layer L₄', and the fifth metal layer L₅'. A smaller quantity of metal layers that are mutually connected through the through hole M' indicates a thinner dielectric layer of the isolation capacitor unit A' and a lower withstand voltage value. A structure of the integrated high voltage isolation capacitor 001 shown in FIG. 1 cannot meet a requirement that the wiring layer requires a small quantity of metal layers but it needs to be ensured that all isolation capacitor units need to be integrated.

FIG. 2 is a diagram of another structure of an integrated high voltage isolation capacitor in the conventional technology. In the structure shown in FIG. 2, an integrated high voltage isolation capacitor 001 includes an isolation capacitor unit A' and a wiring layer B', the isolation capacitor unit A' includes a bottom electrode plate 01 and a top electrode plate 02 that are disposed opposite to each other, and a dielectric layer 03 is disposed between the bottom electrode plate 01 and the top electrode plate 02. The dielectric layer 03 includes two dielectric layers: a silicon dioxide layer 031 and a polymer layer 032. It should be noted that the bottom electrode plate 01 and a second metal layer L₂' are manufactured at a same layer, the top electrode plate 02 and a third metal layer L₃' are manufactured at a same layer, and the dielectric layer 03 is formed at the second metal layer L₂' and extends across the wiring layer B'.

Continuing to refer to the structure shown in FIG. 2, a thickness d' of the dielectric layer 03 is also limited by a spacing d' between the second metal layer L₂' and the third metal layer L_{3'}. The dielectric layer 03 crosses the entire wiring layer B'. Therefore, the dielectric layer needs to be provided with a through hole with a high aspect ratio, to perform a mutual connection. In this case, process difficulty and costs are increased, and a characteristic of an integrated circuit is also affected.

In view of this, embodiments of this application provide an integrated high voltage isolation capacitor, a manufacturing method thereof, and a digital capacitive isolator, to provide an integrated high voltage isolation capacitor that can meet different withstand voltage requirements and is easy to manufacture.

Terms used in the following embodiments are merely intended to describe specific embodiments, but are not intended to limit this application. The terms "one", "a" and "this" of singular forms used in this specification and the appended claims of this application are also intended to include expressions such as "one or more", unless otherwise specified in the context clearly.

Referring to "one embodiment", "some embodiments", or the like described in this specification means that specific features, structures, or features described with reference to embodiments are included in one or more embodiments of this application. Therefore, statements such as "in an embodiment", "in some embodiments", "in some other embodiments", and "in other embodiments" that appear at different places in this specification do not necessarily mean referring to a same embodiment. Instead, the statements mean "one or more but not all of embodiments", unless otherwise specifically emphasized in another manner. The terms "include", "have", and their variants all mean "include but are not limited to", unless otherwise specifically emphasized in another manner.

The following clearly and completely describes the technical solutions in embodiments of this application with reference to the accompanying drawings in embodiments of this application.

It should be noted that the integrated high voltage isolation capacitor provided in embodiments of this application is integrated into the digital capacitive isolator. In addition to the integrated high voltage isolation capacitor, the digital capacitive isolator including the integrated high voltage isolation capacitor is protected in embodiments of this application. For a clearer understanding of the integrated high voltage isolation capacitor provided in embodiments of this application, a structure of the integrated high voltage isolation capacitor is first described. It should be understood that the integrated high voltage isolation capacitor includes one or more isolation capacitor units. It should be understood that, based on a use requirement, the integrated high voltage isolation capacitor may be selected to include a single isolation capacitor unit, or a plurality of isolation capacitor units may be selected to be connected in series, to improve a withstand voltage value of the integrated high voltage isolation capacitor.

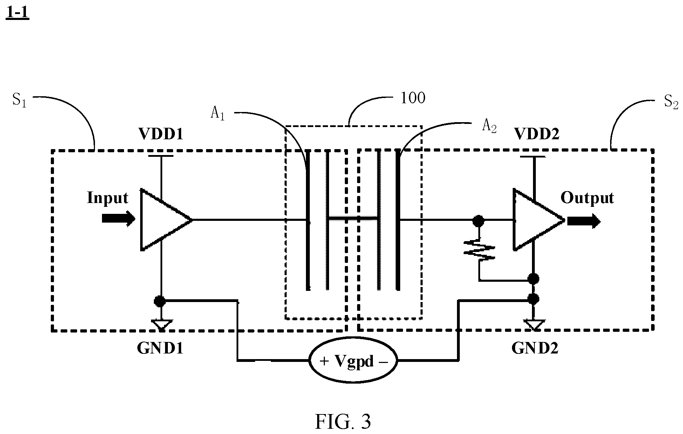

FIG. 3 is an example diagram of a line inside a digital capacitive isolator 1-1 according to an embodiment of this application. It should be noted that, an isolation capacitor unit A₁ and an isolation capacitor unit A₂ are shown in a structure shown in FIG. 3, and the isolation capacitor unit A₁ and the isolation capacitor unit A₂ are connected in series, to improve a withstand voltage value of an integrated high voltage isolation capacitor 100 provided in this embodiment of this application. During manufacturing, the isolation capacitor unit A₁ on the left and an input end are integrated into a chip S₁ on the left, and the isolation capacitor unit A₂ on the right and an output end are integrated into a chip S₂ on the right. Finally, the left chip and the right chip are package together, to form one chip.

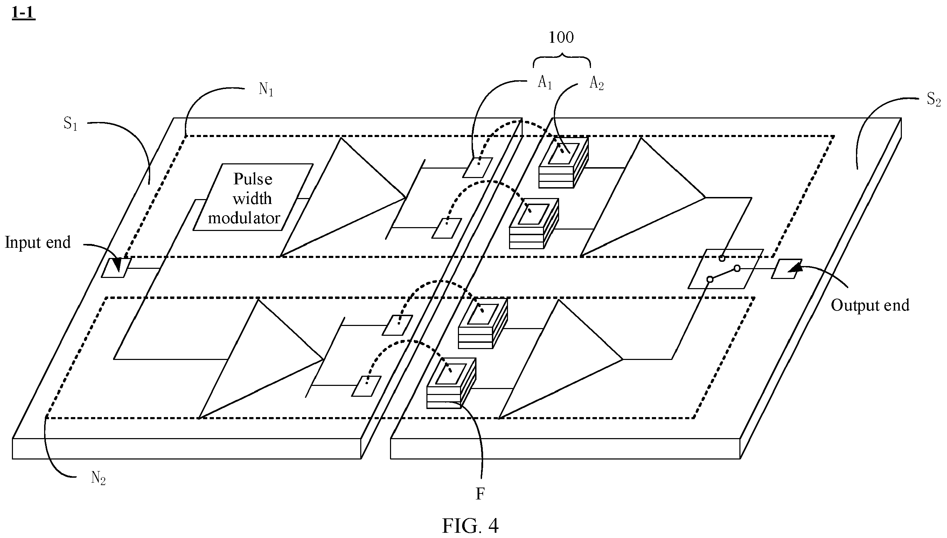

Certainly, the diagram of the line inside the digital capacitive isolator 1-1 provided in this embodiment of this application is not limited to the structure shown in FIG. 3. FIG. 4 is a diagram of another line inside a digital capacitive isolator 1-1 according to an embodiment of this application. In a structure shown in FIG. 4, the chip S₁ on the left is a transmission chip, the chip S₂ on the right is a receiving chip, and the chip S₁ and the chip S₂ form an entire chip. Two channels of a high frequency channel N₁ and a low frequency channel N₂ are connected between the input end and the output end in the entire chip, and the output end may be selectively connected to the high frequency channel N₁ or the low frequency channel N₂. Specifically, two integrated high voltage isolation capacitors 100 formed by connecting the isolation capacitor unit A₁ and the isolation capacitor unit A₂ in series are connected in parallel on each of the high frequency channel N₁ and the low frequency channel N₂. It should be noted that each isolation capacitor unit A₂ is connected to the output terminal by using a high voltage cap F, and a pulse width modulator (pulse width modulation, PWM) is disposed on the high frequency channel N₁.

The isolation capacitor unit A₁ and the isolation capacitor unit A₂ are used as an example, and a principle of connecting capacitors in series and parallel is as follows:

When two capacitors are connected in series, a total withstand voltage value is a sum of withstand voltage values of the two capacitors, and a capacity is one in a sum of reciprocals of capacities of the two capacitors. When two capacitors are connected in parallel, a withstand voltage value is a lower withstand voltage value in withstand voltage values of the two capacitors, and a capacity is a sum of capacities of the two capacitors. In other words, when the two capacitors are connected in series, the withstand voltage value is increased, and the capacity decreases. When the two capacitors are connected in parallel, the withstand voltage value is unchanged, and the capacity is increased. Certainly, a connection relationship between isolation capacitor units in the digital capacitive isolators 1-1 provided in this embodiment of this application may be changed based on a requirement. Details are not described herein again.

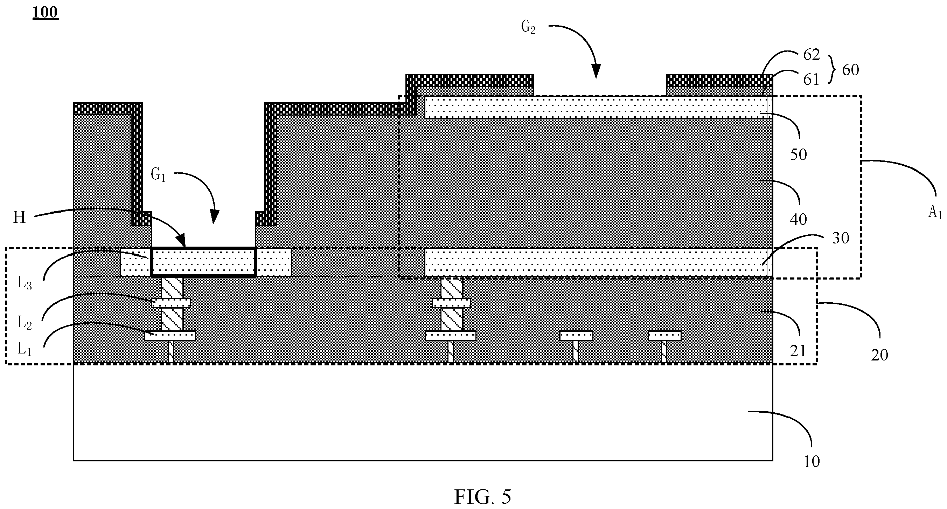

FIG. 5 is a schematic diagram of a structure of a film layer in an integrated high voltage isolation capacitor 100 according to an embodiment of this application. It should be noted that only one isolation capacitor unit A₁ is shown in the structure shown in FIG. 5. Referring to the structure shown in FIG. 5, the integrated high voltage isolation capacitor 100 includes a substrate, a semiconductor component 10, a wiring layer 20, and the isolation capacitor unit A₁ that are sequentially disposed in a stacked manner. For example, a first metal layer L₁, a second metal layer L₂, and a third metal layer L₃ are disposed at the wiring layer 20. Certainly, a quantity of metal layers at the wiring layer 20 is not limited thereto, and may be set based on a requirement. Details are not described herein again. The isolation capacitor unit A₁ is disposed on a top side of the wiring layer 20, and a vertical projection of the isolation capacitor unit A₁ on the substrate and the semiconductor component 10 does not overlap with a vertical projection, of a bonding part H that is of the wiring layer 20 and that is used for packaging and wire bonding, on the substrate and the semiconductor component 10. In a direction in which the substrate and the semiconductor component 10 point to the wiring layer 20, each isolation capacitor unit A₁ includes a bottom electrode plate 30, a dielectric structure layer 40, and a top electrode plate 50 that are sequentially disposed in a stacked manner. In other words, the dielectric structure layer 40 of the isolation capacitor unit A₁ does not cover the bonding part H of the wiring layer, to help connect the wiring layer 20 and an external line, so as to simplify a manufacturing process and reduce production costs.

Continuing to refer to the structure shown in FIG. 5, the isolation capacitor unit A₁ in the integrated high voltage isolation capacitor 100 provided in this embodiment of this application is disposed on the top side of the wiring layer 20. A withstand voltage value of the isolation capacitor unit A₁ can be adjusted by directly adjusting a thickness of the dielectric structure layer 40. Because the thickness of the dielectric structure layer 40 in the integrated high voltage isolation capacitor 100 provided in this application does not depend on a quantity of metal layers at the wiring layer 20, isolation capacitor units A₁ obtained at wiring layers 20 with different quantities of metal layers may be the same. For example, when there are a small quantity of mutually connected metal layers in a back-end process of the wiring layer 20, the isolation capacitor unit A₁ in the integrated high voltage isolation capacitor 100 provided in this embodiment of this application may still have a high withstand voltage value.

Continuing to refer to the structure shown in FIG. 5, the dielectric structure layer 40 may be of a single-layer structure. Specifically, the dielectric structure layer 40 may include only a first dielectric layer, and a manufacturing material of the first dielectric layer is silicon dioxide. The first dielectric layer may be obtained in a single plasma enhanced chemical vapor deposition (plasma enhanced chemical vapor deposition, PECVD) method of tetraethyl orthosilicate (tetraethyl orthosilicate, TEOS). It should be noted that, a withstand voltage value of silicon dioxide with a unit thickness is approximately 500 Vrms/um, and the withstand voltage value of the isolation capacitor unit A₁ may be improved by manufacturing the first dielectric layer 40 by using the silicon dioxide. For example, in a specific setting, it may be set that a thickness of the first dielectric layer may be 1 um to 12 um in the direction in which the substrate and the semiconductor component 10 point to the wiring layer 20.

It should be noted that, because the wiring layer 20 is filled with a silicon dioxide layer 21, a filler of the dielectric structure layer 40 and a filler of the silicon dioxide layer 21 have a same displaying pattern in FIG. 5. To clearly illustrate the dielectric structure layer 40, a dashed line is used for example separation herein.

Continuing to refer to the structure shown in FIG. 5, the third metal layer L₃ at the wiring layer 20 in the integrated high voltage isolation capacitor 100 provided in this embodiment of this application is used as top metal TM. During specific disposing of the integrated high voltage isolation capacitor 100, it may be set that the TM and the bottom electrode plate 30 are manufactured at a same layer. In other words, the bottom electrode plate 30 of the isolation capacitor unit A₁ and the top metal TM of the wiring layer 20 share a same layer of metal. Because the isolation capacitor unit A₁ is disposed on the top side of the wiring layer 20, a setting of the quantity of metal layers at the wiring layer 20 does not affect the isolation capacitor unit A₁. Therefore, the isolation capacitor unit A₁ in the integrated high voltage isolation capacitor 100 provided in this embodiment of this application is compatible with wiring layers with different quantities of metal layers, to implement a large-scale application of a standard process. In addition, it should be noted that because the TM is usually thick and reaches a micron level, the TM is usually used as the bonding part H used for packaging and wire bonding.

There are many possibilities of a manufacturing material of the top electrode plate 50 during disposing of the isolation capacitor unit A₁. For example, the manufacturing material of the top electrode plate 50 may be aluminum or copper. It should be understood that a manufacturing process of the top electrode plate 50 manufactured by using aluminum is simpler, and costs may be reduced.

Certainly, a passivation layer 60 shown in FIG. 5 may be further formed on one side that is of the top electrode plate 50 and that faces away from the substrate and the semiconductor component 10, to further protect the isolation capacitor unit A₁. For example, the passivation layer 60 may include a silicon dioxide thin film 61 and a silicon carbide thin film 62 disposed in a direction that faces away from the substrate and the semiconductor component 10.

It should be noted that the passivation layer 60 is provided with a through hole G₁ at a bonding part H corresponding to the wiring layer 20, to help connect the third metal layer L₃ and the external line. In addition, the passivation layer 60 may be provided with a through hole G₂ at a part corresponding to the isolation capacitor unit A₁, to help connect the isolation capacitor unit A₁ and another isolation capacitor unit.

It should be noted that, during specific disposing of a structure of the isolation capacitor unit A₁, the dielectric structure layer 40 between the bottom electrode plate 30 and the top electrode plate 50 further has another disposing form in addition to the structure shown in FIG. 5. The dielectric structure layer 40 may be specifically in at least one of the following several disposing forms.

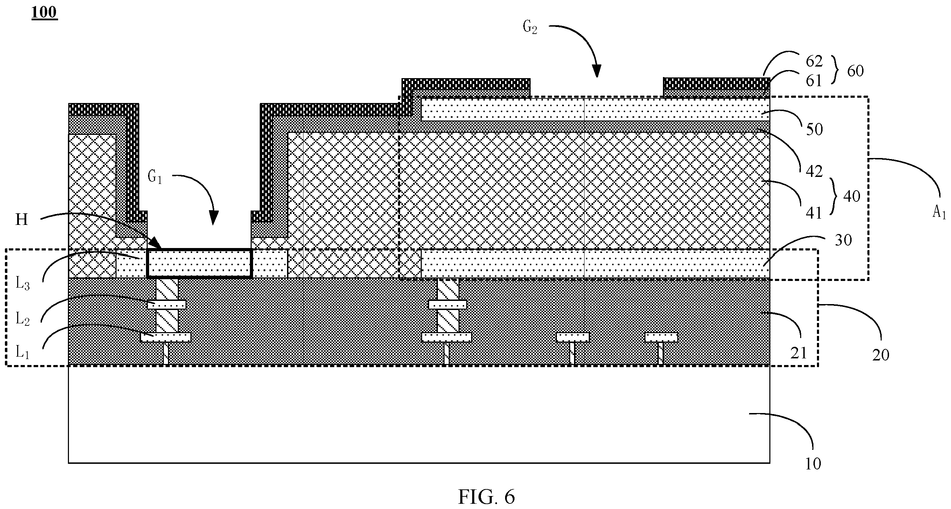

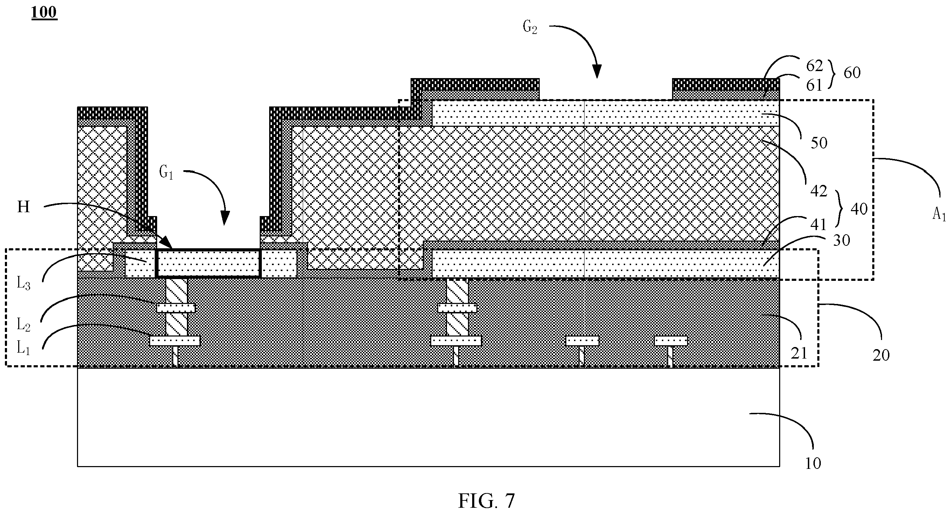

The dielectric structure layer 40 is of a double-layer structure. In a possible implementation, referring to a structure shown in FIG. 6, in the direction in which the substrate and the semiconductor component 10 point to the wiring layer 20, the dielectric structure layer 40 includes a first dielectric layer 41 and a second dielectric layer 42 that are disposed in a stacked manner. A manufacturing material of the first dielectric layer 41 may be photosensitive polyimide, and a manufacturing material of the second dielectric layer 42 may be silicon dioxide. In another possible implementation, referring to a structure shown in FIG. 7, a manufacturing material of the first dielectric layer 41 may alternatively be silicon dioxide, and a manufacturing material of the second dielectric layer 42 may alternatively be photosensitive polyimide. It should be noted that, because the wiring layer 20 is filled with a silicon dioxide layer 21, a filler of the dielectric structure layer 40 and a filler of the silicon dioxide layer 21 have a same displaying pattern in FIG. 7. To clearly illustrate the dielectric layer 40, a dashed line is used for example separation herein.

It should be understood that, when the dielectric structure layer 40 is of a double-layer structure, a manufacturing material of one of the first dielectric layer 41 or the second dielectric layer 42 is photosensitive polyimide. Because the photosensitive polyimide has a characteristic similar to that of a photoresist, a uniform film with a specific thickness may be obtained in a manufacturing process, and a customized pattern may be realized. It should be noted that a withstand voltage value of photosensitive polyimide with a unit thickness is approximately 300 Vrms/um, and the withstand voltage value of the isolation capacitor unit A₁ may be adjusted by adjusting the unit thickness of the photosensitive polyimide. Specifically, when the photosensitive polyimide is used as the first dielectric layer 41 or the second dielectric layer 42, a thickness of the photosensitive polyimide can be freely adjusted to meet different withstand voltage requirements. In this case, there is high flexibility, a manufacturing time period can be reduced, and costs can be reduced.

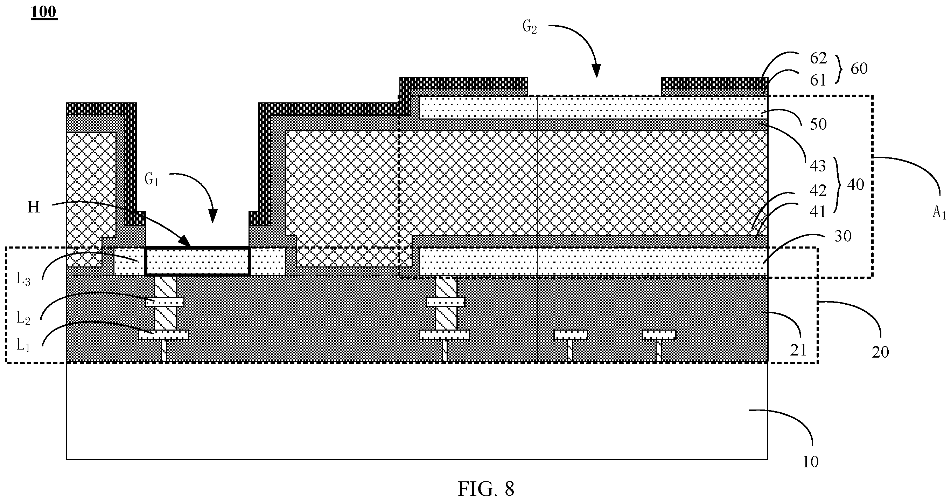

The dielectric structure layer 40 is of a three-layer structure. In a possible implementation, referring to a structure shown in FIG. 8, in the direction in which the substrate and the semiconductor component 10 point to the wiring layer 20, the dielectric structure layer 40 includes a first dielectric layer 41, a second dielectric layer 42, and a third dielectric layer 43 that are disposed in a stacked manner. A manufacturing material of the first dielectric layer 41 is silicon dioxide, a manufacturing material of the second dielectric layer 42 is photosensitive polyimide, and a manufacturing material of the third dielectric layer 43 is silicon dioxide.

It should be understood that the first dielectric layer 41, the second dielectric layer 42, and the third dielectric layer 43 form a sandwich structure, and a thickness of the second dielectric layer 42 is thick to adjust the withstand voltage value of the isolation capacitor unit A₁. It should be noted that the second dielectric layer 42 manufactured by using the photosensitive polyimide is tightly wrapped by the first dielectric layer 41 and the second dielectric layer 42, to prevent the polyimide from absorbing moisture in an environment and a process, and improve reliability of the isolation capacitor unit A₁. In addition, because the photosensitive polyimide has a characteristic similar to that of a photoresist, a uniform film with a specific thickness may be obtained in a manufacturing process, and a customized pattern may be realized. When the photosensitive polyimide is used as the second dielectric layer 42, a thickness of the photosensitive polyimide can be freely adjusted to meet different withstand voltage requirements. In this case, there is high flexibility, a manufacturing time period can be reduced, and costs can be reduced.

In a specific setting, it may be set that in the direction in which the substrate and the semiconductor component 10 point to the wiring layer 20, a thickness of the first dielectric layer 41 is 0.3 um to 1 um, a thickness of the second dielectric layer 42 is 5 um to 30 um, and a thickness of the third dielectric layer 43 is 0.3 um to 1 um. It should be understood that, such a disposing form may meet a requirement of the isolation capacitor unit A₁ for the withstand voltage value. For example, if a withstand voltage value of the single isolation capacitor unit A₁ is approximately 5000 Vrms, the thickness of the first dielectric layer 41 and the thickness of the third dielectric layer 43 may be set to be 0.5 um, and the thickness of the second dielectric layer 42 may be 15 um.

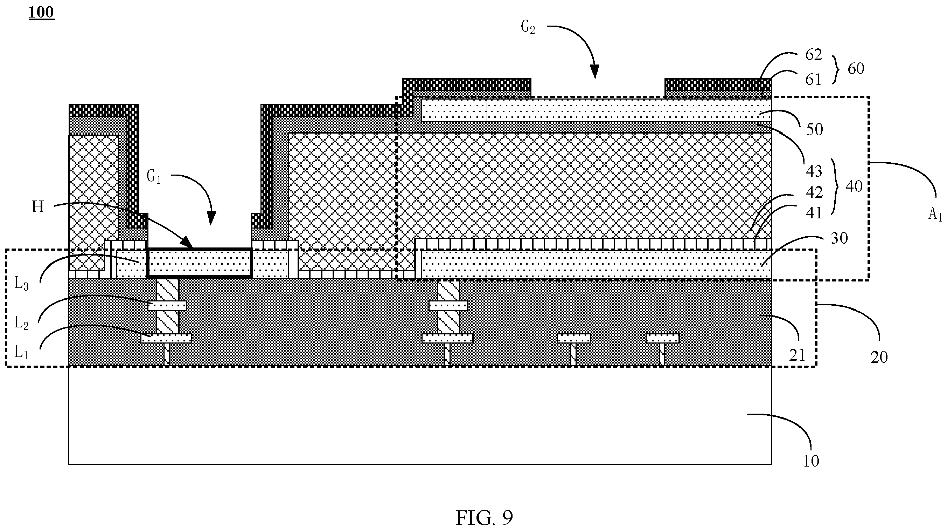

In another possible implementation, referring to a structure shown in FIG. 9, in the direction in which the substrate and the semiconductor component 10 point to the wiring layer 20, the dielectric structure layer 40 includes a first dielectric layer 41, a second dielectric layer 42, and a third dielectric layer 43 that are disposed in a stacked manner. A manufacturing material of the first dielectric layer 41 is silicon nitride, a manufacturing material of the second dielectric layer 42 is photosensitive polyimide, and a manufacturing material of the third dielectric layer 43 is silicon dioxide.

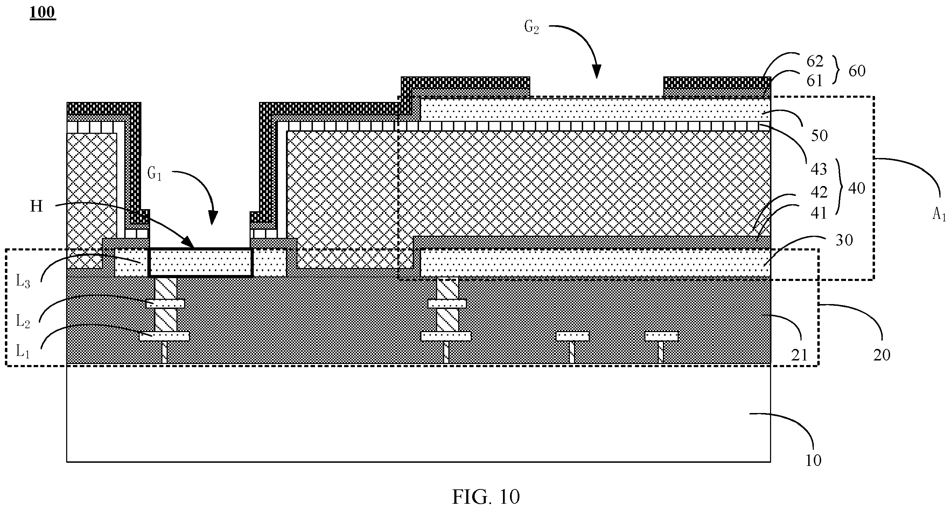

In another possible implementation, referring to a structure shown in FIG. 10, in the direction in which the substrate and the semiconductor component 10 point to the wiring layer 20, the dielectric structure layer 40 includes a first dielectric layer 41, a second dielectric layer 42, and a third dielectric layer 43 that are disposed in a stacked manner. A manufacturing material of the first dielectric layer 41 is silicon dioxide, a manufacturing material of the second dielectric layer 42 is photosensitive polyimide, and a manufacturing material of the third dielectric layer 43 is silicon nitride.

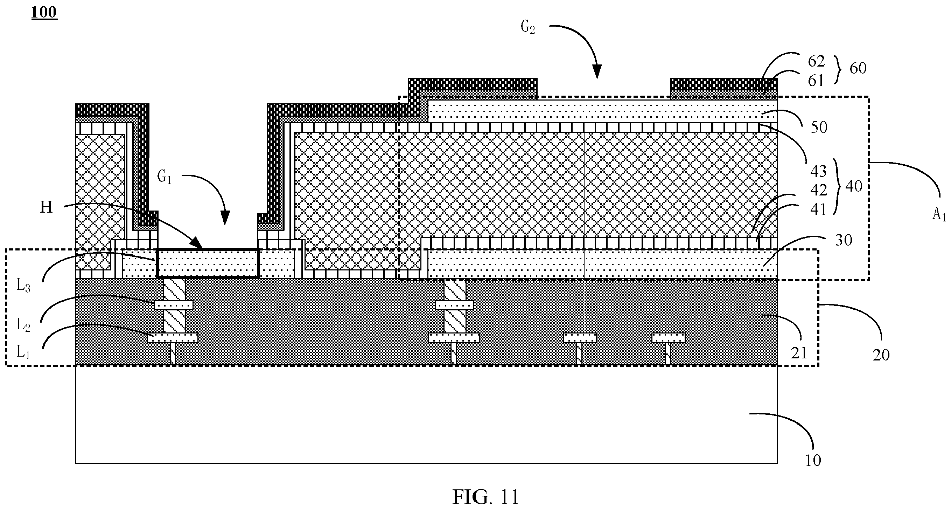

In another possible implementation, referring to a structure shown in FIG. 11, in the direction in which the substrate and the semiconductor component 10 point to the wiring layer 20, the dielectric structure layer 40 includes a first dielectric layer 41, a second dielectric layer 42, and a third dielectric layer 43 that are disposed in a stacked manner. A manufacturing material of the first dielectric layer 41 is silicon nitride, a manufacturing material of the second dielectric layer 42 is photosensitive polyimide, and a manufacturing material of the third dielectric layer 43 is silicon nitride.

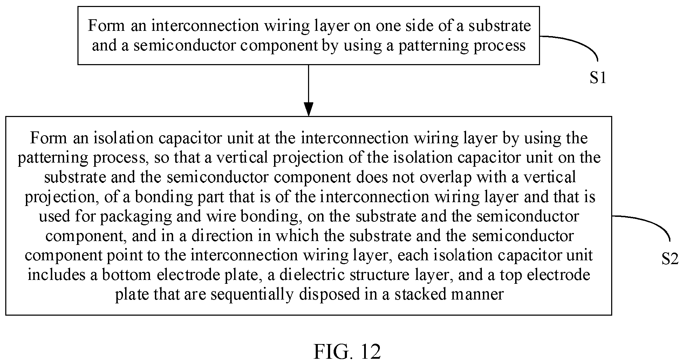

With reference to FIG. 8, as shown in content shown in FIG. 12, an embodiment of this application further provides a manufacturing method for an integrated high voltage isolation capacitor 100. The manufacturing method includes the following steps.
Step S1: Form a wiring layer 20 on one side of a substrate and a semiconductor component 10 by using a patterning process.
Step S2: Form an isolation capacitor unit A₁ at the wiring layer 20 by using the patterning process, so that a vertical projection of the isolation capacitor unit A₁ on the substrate and the semiconductor component 10 does not overlap with a vertical projection, of a bonding part H that is of the wiring layer 20 and that is used for packaging and wire bonding, on the substrate and the semiconductor component 10, and in a direction in which the substrate and the semiconductor component 10 point to the wiring layer 20, each isolation capacitor unit A₁ includes a bottom electrode plate 30, a dielectric structure layer 40, and a top electrode plate 50 that are sequentially disposed in a stacked manner.

In the integrated high voltage isolation capacitor 100 manufactured in the manufacturing method, the isolation capacitor unit A₁ is disposed on a top side of the wiring layer 20, namely, one side that is of the wiring layer 20 and that faces away from the substrate and the semiconductor component 10. A withstand voltage value of the isolation capacitor unit A₁ can be adjusted by directly adjusting a thickness of the dielectric structure layer 40. It should be understood that the thickness of the dielectric structure layer 40 in the integrated high voltage isolation capacitor 100 provided in this application does not depend on a quantity of metal layers at the wiring layer 20, and isolation capacitor units A₁ obtained at wiring layers 20 with different quantities of metal layers may be the same. For example, when there are a small quantity of mutually connected metal layers in a back-end process of the wiring layer 20, the isolation capacitor unit A₁ in the integrated high voltage isolation capacitor 100 provided in this embodiment of this application may still have a high withstand voltage value. In addition, the dielectric structure layer 40 of the isolation capacitor unit A₁ does not cover the bonding part H of the wiring layer, to help connect the wiring layer 20 and an external line, so as to simplify a manufacturing process and reduce production costs.

Continuing to refer to FIG. 8, as shown in the structure shown FIG. 12, when the isolation capacitor unit A₁ is formed at the wiring layer 20 by using the patterning process in step S2, the method includes the following example steps:
Step S201: Manufacture the bottom electrode plate 30 by using the patterning process.
Step S202: Form a first dielectric layer 41 on the bottom electrode plate 30 by using one of a silicon dioxide material or a silicon nitride material.
Step S203: Form a second dielectric layer 42 at the first dielectric layer 41 by using a polyimide material.
Step S204: Form a third dielectric layer 43 at the second dielectric layer 42 by using one of a silicon dioxide material or a silicon nitride material.
Step S205: Form a top electrode plate 50 at the third dielectric layer 43.

It should be understood that the first dielectric layer 41, the second dielectric layer 42, and the third dielectric layer 43 form the dielectric structure layer 40 and form a sandwich structure. A second dielectric layer 42 manufactured by using photosensitive polyimide is tightly wrapped by the first dielectric layer 41 and the second dielectric layer 42, to prevent the polyimide from absorbing moisture in an environment and a process, and improve reliability of the isolation capacitor unit A₁. In addition, because the photosensitive polyimide has a characteristic similar to that of a photoresist, a uniform film with a specific thickness may be obtained in a manufacturing process, and a customized pattern may be realized. It should be noted that, when the photosensitive polyimide is used as the second dielectric layer 42, a thickness of the photosensitive polyimide can be freely adjusted to meet different withstand voltage requirements. In this case, there is high flexibility, a manufacturing time period can be reduced, and costs can be reduced.

A method for forming the second dielectric layer 42 at the first dielectric layer 41 by using the polyimide material in step S203 includes the following example steps:
Step S2031: Spin-coating the polyimide, to obtain a uniform film with a specific thickness.
Step S2032: Perform photolithography and development on the uniform film, to obtain a pattern of the second dielectric layer 42.
Step S2033: Perform a high-temperature film hardening process on the pattern of the second dielectric layer 42, to obtain a stable second dielectric layer 42.

Because of spin-coating of the photosensitive polyimide and a photolithography process, the thickness of the photosensitive polyimide can be freely adjusted to meet different withstand voltage requirements. In this way, there is high flexibility. In addition, the second dielectric layer 42 supports local customization because of a manufacturing process and a material characteristic of the photosensitive polyimide, to reduce process difficulty and costs without affecting an interconnection structure and performance of a pre-designed wiring layer. It should be noted that because a passivation process in which polyimide is used in a back-end process is completely reused for the photosensitive polyimide, manufacturing costs may not be increased.

A method for forming the bottom electrode plate 30 in step S201 specifically includes:
manufacturing top metal TM (namely, a third metal layer L₃) of the wiring layer 20 and the bottom electrode plate 30 at a same layer by using the patterning process.

In other words, the bottom electrode plate 30 of the isolation capacitor unit A₁ and the top metal TM of the wiring layer 20 share a same layer of metal. When the TM and the bottom electrode plate 30 are manufactured at a same layer, because the isolation capacitor unit A₁ is disposed on a top side of the wiring layer 20, a setting of the quantity of metal layers at the wiring layer 20 does not affect the isolation capacitor unit A₁. Therefore, the isolation capacitor unit A₁ in the integrated high voltage isolation capacitor 100 provided in this embodiment of this application is compatible with wiring layers with different quantities of metal layers, to implement a large-scale application of a standard process.

For example, the manufacturing method for the integrated high voltage isolation capacitor 100 provided in this embodiment of this application is used to manufacture the structure shown in FIG. 8. A specific manufacturing procedure is provided herein:
after manufacturing of the top metal TM process is completed based on a CMOS standard, depositing one layer of silicon dioxide on the TM, to form the first dielectric layer 41; spin-coating the photosensitive polyimide, to obtain the uniform film with a specific thickness; performing photolithography and development, to obtain a target pattern; performing high-temperature solidification to obtain a stable polyimide thin film, so as to form the second dielectric layer 42; depositing another layer of silicon dioxide, to form the third dielectric layer 43; depositing metal of the top electrode plate, performing photolithography, and etching a required pattern on the top electrode plate 50; depositing a silicon dioxide thin film 61 and a silicon nitride thin film layer 62 as the passivation layer 60; and after photolithography is performed on the passivation layer 60, etching the bonding part H used for packaging and wire bonding.

In conclusion, in the integrated high voltage isolation capacitor 100 provided in this embodiment of this application, the dielectric structure layer 40 of the isolation capacitor unit A₁ is stacked on the top metal TM of the wiring layer 20, locally customized coverage is implemented by using a photolithography process, and then, a layer of metal is stacked on the dielectric structure layer 40 and is used as the top electrode plate 50, to obtain the integrated high voltage isolation capacitor 100. It should be noted that, the manufacturing method for the integrated high voltage isolation capacitor 100 provided in this embodiment of this application is highly compatible with a standard CMOS process, there is high reliability, a passivation process in which polyimide is used in a back-end process is completely reused for the photosensitive polyimide, and manufacturing costs may not be increased. Compared with an original process, in this embodiment of this application, only two steps of depositing a thin layer of silicon dioxide and one step of depositing aluminum and performing etching by using a photolithography process of aluminum are added. In addition, costs of depositing silicon dioxide for approximately 10 times are reduced, and costs of disposing a through hole at the dielectric structure layer 40 can be reduced.

The foregoing descriptions are merely specific implementations of this application, but are not intended to limit the protection scope of this application. Any variation or replacement readily figured out by a person skilled in the art within the technical scope disclosed in this application shall fall within the protection scope of this application. Therefore, the protection scope of this application shall be subject to the protection scope of the claims.

## Claims

1. An integrated high voltage isolation capacitor, comprising:
a substrate and a semiconductor component;
a wiring layer located on one side of the substrate and the semiconductor component, wherein the wiring layer has a bonding part used for packaging and wire bonding; and
at least one isolation capacitor unit located on a side that is of the wiring layer and that faces away from the substrate and the semiconductor component, wherein a vertical projection of the isolation capacitor unit on the substrate and the semiconductor component does not overlap with a vertical projection of the bonding part on the substrate and the semiconductor component; and in a direction in which the substrate and the semiconductor component point to the wiring layer, the isolation capacitor unit comprises a bottom electrode plate, a dielectric structure layer, and a top electrode plate that are sequentially disposed in a stacked manner.

2. The integrated high voltage isolation capacitor according to claim 1, wherein the dielectric structure layer comprises a first dielectric layer, and a manufacturing material of the first dielectric layer is silicon dioxide.

3. The integrated high voltage isolation capacitor according to claim 2, wherein in the direction in which the substrate and the semiconductor component point to the wiring layer, a thickness of the first dielectric layer is 1 um to 12 um.

4. The integrated high voltage isolation capacitor according to claim 1, wherein in the direction in which the substrate and the semiconductor component point to the wiring layer, the dielectric structure layer comprises a first dielectric layer and a second dielectric layer that are disposed in a stacked manner, a manufacturing material of one of the first dielectric layer and the second dielectric layer is silicon dioxide, and a manufacturing material of the other one is photosensitive polyimide.

5. The integrated high voltage isolation capacitor according to claim 1, wherein in the direction in which the substrate and the semiconductor component point to the wiring layer, the dielectric structure layer comprises a first dielectric layer, a second dielectric layer, and a third dielectric layer that are disposed in a stacked manner, a manufacturing material of the first dielectric layer is one of silicon dioxide or silicon nitride, a manufacturing material of the second dielectric layer is photosensitive polyimide, and a manufacturing material of the third dielectric layer is one of silicon dioxide or silicon nitride.

6. The integrated high voltage isolation capacitor according to claim 5, wherein in the direction in which the substrate and the semiconductor component point to the wiring layer, a thickness of the first dielectric layer is 0.3 um to 1 um, a thickness of the second dielectric layer is 5 um to 30 um, and a thickness of the third dielectric layer is 0.3 um to 1 um.

7. The integrated high voltage isolation capacitor according to any one of claims 1 to 6, wherein the wiring layer comprises top metal TM, and the TM and the bottom electrode plate are manufactured at a same layer.

8. The integrated high voltage isolation capacitor according to any one of claims 1 to 7, wherein a manufacturing material of the top electrode plate is aluminum.

9. The integrated high voltage isolation capacitor according to any one of claims 1 to 8, further comprising a passivation layer located on a side that is of the isolation capacitor unit and that faces away from the wiring layer.

10. A digital capacitive isolator, comprising the integrated high voltage isolation capacitor according to any one of claims 1 to 9.
